# EUROPEAN PATENT APPLICATION

(11) **EP 4 764 639 A1**
(43) Date of publication of application: **24.06.2026**
(21) Application number: 24864254.8
(22) Date of filing: 12.07.2024
(51) Int. Cl.: G02B 6/42

(54) **PACKAGING STRUCTURE, OPTICAL MODULE, AND OPTICAL COMMUNICATION DEVICE**

(30) Priority: 11.09.2023 CN 202311174779
(71) Applicant: HUAWEI TECHNOLOGIES CO., LTD., Shenzhen 518129 (CN)
(72) Inventor: LIU, Yuan, Shenzhen, Guangdong 518129 (CN); LIU, Tao, Shenzhen, Guangdong 518129 (CN); SHAO, Haifeng, Shenzhen, Guangdong 518129 (CN); DONG, Hao, Shenzhen, Guangdong 518129 (CN); SU, Changzheng, Shenzhen, Guangdong 518129 (CN)
(74) Representative: Isarpatent
(86) International application number: PCT/CN2024/105232
(87) International publication number: WO 2025/055530

(57) **Abstract**

This application provides a package structure, an optical module, and an optical communication device. The package structure is a transistor outline package structure. The package structure includes: a can, provided with a transparent window; a header, mated with the can to form a cavity structure; and a horizontal cavity surface-emitting laser HCSEL chip, disposed in the cavity structure. A plane in which the HCSEL chip is located is parallel to a mounting surface of the header, and an optical signal emitted by the HCSEL chip is directed toward the transparent window. A detection unit is disposed in the HCSEL chip, and the detection unit is configured to detect power of the optical signal emitted by the HCSEL chip. The horizontal cavity surface-emitting laser chip integrated with the detection unit is disposed in the package structure, so that the simplest package form is implemented, a packaging procedure is simplified, and packaging volume is reduced.

## Description

This application claims priority to Chinese Patent Application No. 202311174779.4, filed with the China National Intellectual Property Administration on September 11, 2023, and entitled "PACKAGE STRUCTURE, OPTICAL MODULE, AND OPTICAL COMMUNICATION DEVICE", which is incorporated herein by reference in its entirety.

### TECHNICAL FIELD

This application relates to the field of optical communication, and in particular, to a package structure, an optical module, and an optical communication device.

### BACKGROUND

An optical communication component is an important hardware component in optical communication services, and a function of the optical communication component is to implement mutual conversion between an electrical signal and an optical signal. With continuous acceleration of optical network services and increasing demands for smooth upgrades, two or more generations of optical network products are compatible and coexist in the market. For example, for passive optical networks, an XG passive optical network and a 10G Ethernet passive optical network achieve compatibility and smooth transition as well as higher-rate network services.

A bottom-layer optical component needs to support simultaneous transmission of a plurality of optical signals with different rates and wavelengths to meet a requirement of coexistence of a plurality of ports with different rates and wavelengths. Therefore, the bottom-layer optical component requires high-density and high-integration packaging in different package forms. Currently, common packaging technologies include a vertical three-dimensional technology and a horizontal packaging technology. In the foregoing packaging technologies, a plurality of material elements need to be mounted a plurality of times in a package, a procedure is complex, packaging takes a long time, and packaging volume is large. Therefore, how to achieve high-density and high-integration packaging is an urgent problem to be resolved.

### SUMMARY

This application provides a package structure, an optical module, and an optical communication device. A horizontal cavity surface-emitting laser chip integrated with a detection unit is disposed in the package structure, so that the simplest package form is implemented, a packaging procedure is simplified, and packaging volume is reduced.

According to a first aspect, a package structure is provided. The package structure is a transistor outline package structure. The package structure includes: a can, provided with a transparent window; a header, mated with the can to form a cavity structure; and a horizontal cavity surface-emitting laser HCSEL chip, disposed in the cavity structure. A plane in which the HCSEL chip is located is parallel to a mounting surface of the header, and an optical signal emitted by the HCSEL chip is directed toward the transparent window. A detection unit is disposed in the HCSEL chip, and the detection unit is configured to detect power of the optical signal emitted by the HCSEL chip.

In the package structure provided in this application, the HCSEL chip is disposed, so that an optical signal is emitted to the transparent window of the can when the chip is horizontally disposed. In a packaging process, no additional optical reflector needs to be added, thereby simplifying a packaging procedure and reducing packaging volume. In addition, based on use of the HCSEL chip, the detection unit is integrated into the HCSEL chip. In a packaging process, no additional monitoring backlight needs to be added, so that a packaging procedure is simplified, packaging volume is reduced, and the simplest package form is implemented.

With reference to the first aspect, in some implementations of the first aspect, the HCSEL chip is in an electroabsorption modulated laser EML form. The HCSEL chip in the EML form includes a light-emitting unit and an electroabsorption unit. The light-emitting unit is configured to emit a light beam. The electroabsorption unit is configured to generate a photocurrent signal. The photocurrent signal is used to modulate the light beam to generate the optical signal emitted by the HCSEL chip. The detection unit is the electroabsorption unit. The power of the optical signal emitted by the HCSEL chip is determined based on the photocurrent signal. In this way, the power of the optical signal emitted by the HCSEL chip can be detected through the photocurrent fed back by the electroabsorption unit, thereby implementing high density and high integration of the HCSEL chip. In addition, no additional backlight monitoring needs to be added to the package structure, and packaging is simplified.

With reference to the first aspect, in some implementations of the first aspect, the horizontal cavity surface-emitting laser chip is in a distributed feedback DFB form, and in the HCSEL chip in the DFB form, the optical detection unit is formed by a photoresistor. The photoresistor is disposed on the HCSEL chip, so that the power of the optical signal emitted by the HCSEL chip can be detected, thereby implementing high density and high integration of the HCSEL chip. In addition, no additional backlight monitoring needs to be added to the package structure, and packaging is simplified.

With reference to the first aspect, in some implementations of the first aspect, the horizontal cavity surface-emitting laser chip includes a first electrode, a second electrode, and a semiconductor substrate. The semiconductor substrate includes a first region, a second region, and an isolation trench. The first region and the second region are respectively located on two sides of the isolation trench. A light-emitting layer and a reflective inclined surface are disposed in the first region. The light-emitting layer includes a first light-emitting facet and a second light-emitting facet. The first light-emitting facet is connected to a side of the semiconductor substrate. The second light-emitting facet is connected to the reflective inclined surface. The detection unit is disposed in the second region. The detection unit and the light-emitting layer are located in a same plane.

In this way, the detection unit is disposed in the chip, so that a high-density and high-integration chip structure is implemented. In addition, based on division of the isolation trenches, the first light-emitting facet of the light-emitting layer is connected to the semiconductor substrate, and the optical signal received by the second detection unit is from the second light-emitting facet of the light-emitting layer, that is, an emission facet that is specifically located on a side of the reflective inclined surface in the specific HCSEL chip, to avoid providing the isolation trench and an isolation region in a reverse direction of the emission facet of the HCSEL chip to place the detection unit, thereby optimizing a chip structure and saving chip space. When one sidewall of the isolation trench is a reflective inclined surface, space can be further saved, and structural design of the HCSEL chip can be optimized.

With reference to the first aspect, in some implementations of the first aspect, the isolation trench includes a first sidewall, and the first sidewall is the reflective inclined surface. That is, a specific position of the isolation trench is defined by the reflective inclined surface, thereby saving space and optimizing the structural design of the HCSEL chip.

With reference to the first aspect, in some implementations of the first aspect, the horizontal cavity surface-emitting laser chip includes a first electrode, a second electrode, and a semiconductor substrate. A light-emitting layer, a reflective inclined surface, a beam splitting unit, and the optical detection unit are disposed in the semiconductor substrate. The light-emitting layer includes a first light-emitting facet and a second light-emitting facet. The first emission facet is connected to a side of the semiconductor substrate. The optical splitting unit includes an input port, a first output port, and a second output port. The input port is connected to the second light-emitting facet. The first output port is connected to the detection unit. The second output port is connected to the reflective inclined surface.

The detection unit is disposed in the chip, so that a high-density and high-integration chip structure is implemented. In addition, the beam splitting unit is provided on the second emission facet of the semiconductor substrate, to avoid providing the isolation trench and an isolation region in a reverse direction of the emission facet of the HCSEL chip to place the detection unit, thereby optimizing a chip structure and saving chip space.

With reference to the first aspect, in some implementations of the first aspect, the package structure further includes a cooler, and the HCSEL chip is flatly attached to the cooler. The cooler is configured to cool the HCSEL chip, to stabilize optical signal output of the HCSEL chip.

With reference to the first aspect, in some implementations of the first aspect, the HCSEL chip includes an emission aperture, and the emission aperture is a spherical structure; and the reflective inclined surface is a spherical structure. In this way, a lens or a structure having a similar effect with the lens is integrated into the chip, to implement a high-density and high-integration chip structure.

With reference to the first aspect, in some implementations of the first aspect,
the package structure is a light-emitting component in a single-transmit mode. The package structure further includes one or more light-emitting chips, and the package structure is a light-emitting component in a multi-transmit mode, to simplify a package structure of a transmit end, reduce packaging volume, and reduce optical component costs; the package structure further includes one or more light-receiving chips, and the package structure is an optical transceiver in a one-transmit-one-receive mode or a one-transmit-multi-receive mode, to simplify package structures of a transmit end and a receive end, reduce packaging volume, and reduce optical component costs; or the package structure further includes one or more light-emitting chips and one or more light-receiving chips, and the package structure is an optical transceiver in a multi-transmit multi-receive mode, to simplify package structures of a transmit end and a receive end, reduce packaging volume, and reduce optical component costs.

According to a second aspect, an optical module is provided, including an electrical chip and the package structure according to any one of the first aspect and the possible implementations of the first aspect. The electrical chip is configured to generate an electrical signal, where the electrical signal carries data. The HCSEL chip is configured to generate an optical signal based on the electrical signal.

With reference to the second aspect, in some implementations of the second aspect, including an electrical chip, a receive optical sub-assembly, and the package structure according to any one of the first aspect and the possible implementations of the first aspect. The electrical chip is configured to generate an electrical signal, where the electrical signal carries data. The HCSEL chip is configured to generate an optical signal based on the electrical signal. The receive optical sub-assembly is configured to receive another optical signal and convert the another optical signal into another electrical signal. The electrical chip is further configured to obtain another piece of data based on the another electrical signal.

According to a third aspect, an optical communication device is provided, including N boards. Each of the N boards includes one or more optical modules according to any one of the second aspect and the possible implementations of the second aspect and the third aspect and the possible implementations of the third aspect.

According to a fourth aspect, a packaging method is provided, and is used to prepare the package structure according to any one of the first aspect and the possible implementations of the first aspect.

According to a fifth aspect, an optical chip is provided, including a first electrode, a second electrode, and a semiconductor substrate. The semiconductor substrate includes a first region, a second region, and an isolation trench. The first region and the second region are respectively located on two sides of the isolation trench. A light-emitting layer and a reflective inclined surface are disposed in the first region. The light-emitting layer includes a first light-emitting facet and a second light-emitting facet. The first light-emitting facet is connected to a side of the semiconductor substrate. The second light-emitting facet is connected to the reflective inclined surface. The detection unit is disposed in the second region. The detection unit and the light-emitting layer are located in a same plane.

In this way, the detection unit is disposed in the chip, so that a high-density and high-integration chip structure is implemented. In addition, based on division of the isolation trenches, the first light-emitting facet of the light-emitting layer is connected to the semiconductor substrate, and the optical signal received by the second detection unit is from the second light-emitting facet of the light-emitting layer, that is, an emission facet that is specifically located on a side of the reflective inclined surface in the specific HCSEL chip, to avoid providing the isolation trench and an isolation region in a reverse direction of the emission facet of the HCSEL chip to place the detection unit, thereby optimizing a chip structure and saving chip space. When one sidewall of the isolation trench is a reflective inclined surface, space can be further saved, and structural design of the HCSEL chip can be optimized.

With reference to the fifth aspect, in some implementations of the fifth aspect, the isolation trench includes a first sidewall, and the first sidewall is the reflective inclined surface. That is, a specific position of the isolation trench is defined by the reflective inclined surface, thereby saving space and optimizing the structural design of the HCSEL chip.

### BRIEF DESCRIPTION OF DRAWINGS

FIG. 1 is a diagram of an EML TO package structure according to an embodiment of this application;
FIG. 2 is a diagram of another EML TO packaging method according to an embodiment of this application;
FIG. 3 is a diagram of another EML TO package structure according to an embodiment of this application;
FIG. 4 is a diagram of another EML TO packaging method according to an embodiment of this application;
FIG. 5 is a diagram of a DFB TO package structure according to an embodiment of this application;
FIG. 6 is a diagram of another EML TO packaging method according to an embodiment of this application;
FIG. 7A and FIG. 7B are a diagram of a package structure including an HCSEL chip in an EML form according to an embodiment of this application;
FIG. 8 is a three-dimensional diagram of a package structure including an HCSEL chip in an EML form according to an embodiment of this application;
FIG. 9 is a diagram of a packaging method including an HCSEL chip in an EML form according to an embodiment of this application;
FIG. 10A and FIG. 10B are a diagram of a package structure including an HCSEL chip in a DFB form according to an embodiment of this application;
FIG. 11 is a three-dimensional diagram of a package structure including an HCSEL chip in a DFB form according to an embodiment of this application;
FIG. 12 is a diagram of a packaging method including an HCSEL chip in a DFB form according to an embodiment of this application;
FIG. 13(a) to FIG. 13(e) are diagrams of a structure of an HCSEL chip according to an embodiment of this application;
FIG. 14A and FIG. 14B are a diagram of a structure of another HCSEL chip according to an embodiment of this application;
FIG. 15A to FIG. 15F are a diagram of a structure of another HCSEL chip according to an embodiment of this application;
FIG. 16A to FIG. 16C are a diagram of a case in which a package structure is a light-emitting component according to an embodiment of this application;
FIG. 17A to FIG. 17D is a diagram of a case in which a package structure is an optical transceiver according to an embodiment of this application;
FIG. 18 shows an optical module according to an embodiment of this application;
FIG. 19 shows another optical module according to an embodiment of this application; and
FIG. 20A and FIG. 20B show an optical communication device according to an embodiment of this application.

### DESCRIPTION OF EMBODIMENTS

The following describes technical solutions of this application with reference to accompanying drawings.

The terms "first" and "second" mentioned below are merely intended for a purpose of description, and shall not be understood as an indication or implication of relative importance or implicit indication of the number of indicated technical features. Therefore, a feature limited by "first" or "second" may explicitly or implicitly include one or more features.

Reference to "one embodiment", "some embodiments", or the like described in this specification means that a specific feature, structure, or characteristic described with reference to the embodiment is included in one or more embodiments of this application. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

In the descriptions of embodiments of this application, orientations or position relationships indicated by terms "up", "down", "vertical", "horizontal", and the like are defined relative to orientations or positions in which parts are schematically placed in the accompanying drawings. It should be understood that these directional terms are relative concepts, and are used for relative description and clarification, but do not indicate or imply that a specified apparatus or component needs to have a specific orientation or be constructed and operated in a specific orientation. These directional terms may vary correspondingly based on changes of positions of the parts in the accompanying drawings, and therefore cannot be understood as a limitation on this application.

In the following embodiments of this application, the terms such as "include", "have", and any variants thereof are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

In embodiments of this application, terms such as "example" or "for example" are used to represent giving an example, an illustration, or a description. Any embodiment or design scheme described with "example" or "for example" should not be explained as being more preferred or having more advantages than another embodiment or design scheme. The term like "example" or "for example" is used to present a related concept in a specific manner for ease of understanding.

In embodiments of this application, a same reference numeral indicates a same component or a same part. In addition, parts in the accompanying drawings are not drawn based on an actual scale. Dimensions and sizes of the parts shown in the figures are merely examples, and should not be understood as a limitation on this application.

An optical communication component is an important hardware component in optical communication services, and a function of the optical communication component is to implement mutual conversion between an electrical signal and an optical signal. With continuous acceleration of optical network services and increasing demands for smooth upgrades, two or more generations of optical network products are compatible and coexist in the market. For example, for passive optical networks, an XG passive optical network (10-Gigabit Passive Optical Network, XG PON) and a 10G Ethernet passive optical network (10G-Ethernet passive optical network, 10G-EPON) achieve compatibility and smooth transition as well as higher-rate network services. A bottom-layer optical component needs to support simultaneous transmission of a plurality of optical signals with different rates and wavelengths to meet a requirement of coexistence of a plurality of ports with different rates and wavelengths. Therefore, the bottom-layer optical component requires high-density and high-integration packaging in different package forms.

An optical module is a core component of optical communication, and a coaxial optical component included in the optical module is an important optoelectronic component for the optical module to implement electrical-to-optical signal conversion and optical-to-electrical signal conversion. Packaging of the coaxial optical component may use a transistor outline (transistor outline, TO) package. The TO package is relatively simple and cost-effective, and is widely used in optical component products in fields such as PON, wireless, and network interconnection protocols. The TO package includes a plurality of modes, for example, a transmit optical sub-assembly (transmit optical sub-assembly, TOSA), a receive optical sub-assembly (receive optical sub-assembly, ROSA), a bidirectional optical sub-assembly (bidirectional optical sub-assembly, BOSA), a triplexer (Triplexer) bidirectional optical sub-assembly, and a quad-optical sub-assembly (Quad-optical sub-assembly, Quad-OSA).

In a TO package structure, a laser chip is a core component, and is configured to emit an optical signal. The laser chip may be classified into an electroabsorption modulation (external modulation laser, EML) form and a distributed feedback (distributed feedback, DFB) form according to a form. The following briefly describes a package structure in an EML form and a package structure in a DFB form.

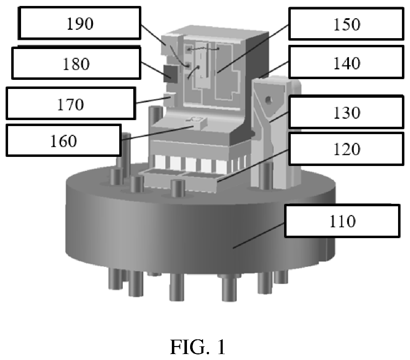

FIG. 1 is a diagram of an EML TO package structure according to an embodiment of this application. The EML TO package structure uses conventional vertical three-dimensional packaging. The package structure includes a header 110, a cooler 120, a radio frequency signal substrate 130, a heat sink 140, a chip 150, a monitoring backlight 160, a first capacitor 170, a thermistor 180, and a second capacitor 190.

The chip 150 and other passive elements are mounted on a mounting surface of the header 110.

The cooler 120 may specifically be a thermoelectric cooler (thermoelectric cooler, TEC), and perform cooling using a thermoelectric effect of a semiconductor material.

The radio frequency signal substrate 130 is configured to transmit a radio frequency signal.

The heat sink 140 is configured to absorb and disperse heat.

The chip 150 may specifically be an EML chip on carrier (chip on carrier, COC), and is configured to receive an externally modulated electrical signal, convert the electrical signal into an optical signal, and output the optical signal.

The monitoring backlight 160 may specifically be a modulation photodiode (modulation photodiode, mPD), and is configured to receive and detect power of the modulated optical signal.

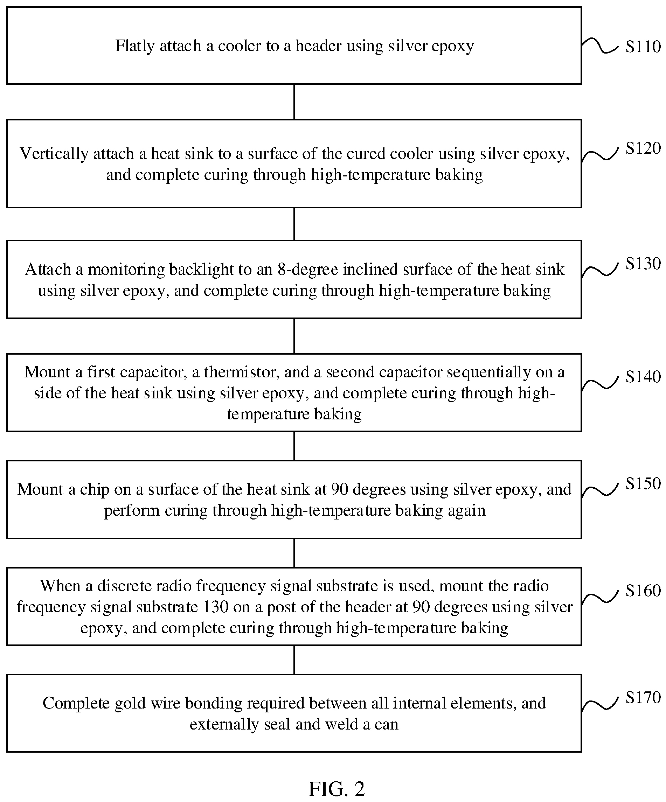

FIG. 2 is a diagram of another EML TO packaging method according to an embodiment of this application. As shown in FIG. 2, corresponding to the EML TO package structure in FIG. 1, a packaging procedure includes steps S110 to S170.

S110: Flatly attach the cooler to the header using silver epoxy; or fasten the cooler to the header through eutectic bonding using Au-Sn solder, and complete curing through high-temperature baking.

S120: Vertically attach the heat sink to a surface of the cured cooler using silver epoxy, and complete curing through high-temperature baking.

S130: Attach the monitoring backlight to an 8-degree inclined surface of the heat sink using silver epoxy, and complete curing through high-temperature baking.

S140: Mount the first capacitor, the thermistor, and the second capacitor sequentially on a side of the heat sink using silver epoxy, and complete curing through high-temperature baking.

S150: Mount the chip on the surface of the heat sink at 90 degrees using silver epoxy, and perform curing through high-temperature baking again.

S160: When a discrete radio frequency signal substrate is used, mount the radio frequency signal substrate 130 on a post of the header at 90 degrees using silver epoxy, and complete curing through high-temperature baking.

S170: Complete gold wire bonding required between all internal elements, and externally seal and weld a can.

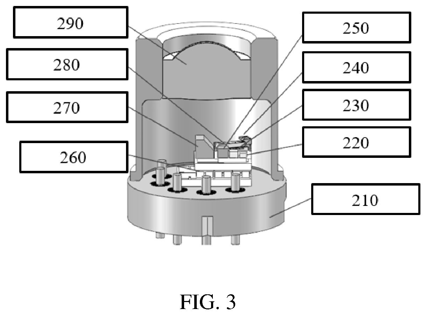

FIG. 3 is a diagram of another EML TO package structure according to an embodiment of this application. The EML TO package structure uses horizontal packaging. The package structure includes a header 210, a thermistor 220, a first capacitor 230, a monitoring backlight 240, a second capacitor 250, a cooler 260, an optical reflector 270, a chip 280, and a can 290.

The header 210, the thermistor 220, the first capacitor 230, the monitoring backlight 240, the second capacitor 250, the cooler 260, and the chip 280 are similar to those in FIG. 1, and details are not described herein again.

In addition, the optical reflector 270 is further disposed in the horizontal package structure, and is configured to change an optical signal emission direction of the chip 280.

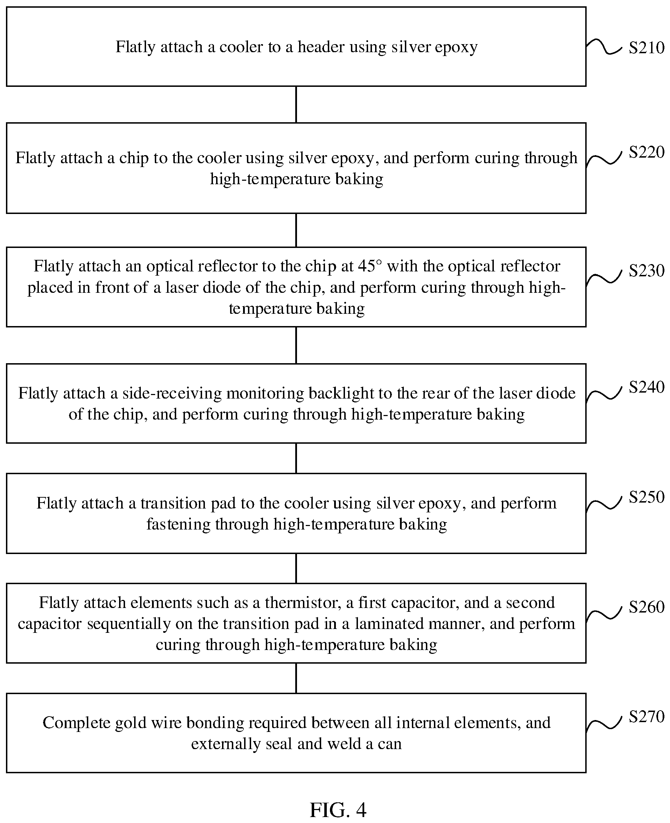

FIG. 4 is a diagram of another EML TO packaging method according to an embodiment of this application. Corresponding to the EML TO package structure in FIG. 3, a specific packaging procedure includes steps S210 to S270.

S210: Flatly attach the cooler to the header using silver epoxy; or fasten the cooler to the header through eutectic bonding using Au-Sn solder, and complete curing through high-temperature baking.

S220: Flatly attach the chip to the cooler using silver epoxy, and perform curing through high-temperature baking.

S230: Flatly attach the optical reflector to the chip at 45° with the optical reflector placed in front of a laser diode of the chip, and perform curing through high-temperature baking.

S240: Flatly attach the side-receiving monitoring backlight to the rear of the laser diode of the chip, and perform curing through high-temperature baking.

S250: Flatly attach a transition pad to the cooler using silver epoxy, and perform fastening through high-temperature baking.

S260: Flatly attach elements such as the thermistor, the first capacitor, and the second capacitor sequentially on the transition pad in a laminated manner, and perform curing through high-temperature baking.

S270: Complete gold wire bonding required between all internal elements, and externally seal and weld the can.

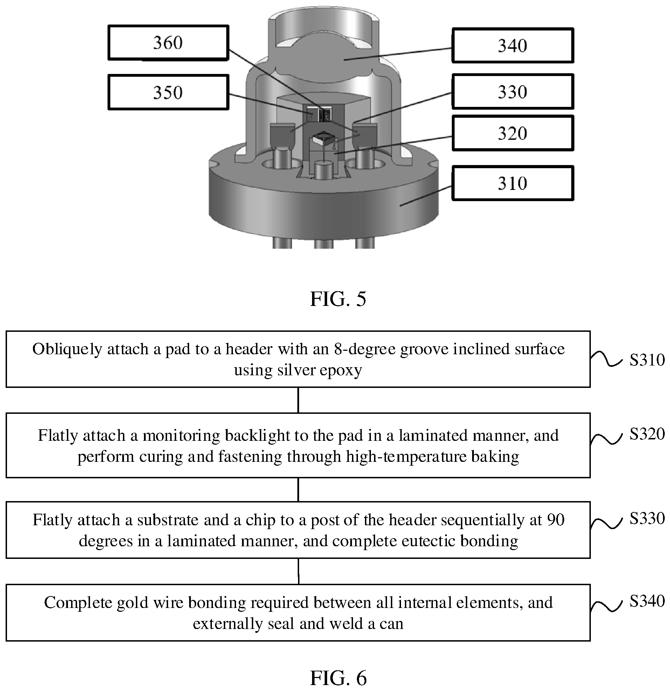

FIG. 5 is a diagram of a DFB TO package structure according to an embodiment of this application. The DFB TO package structure uses a conventional vertical three-dimensional technology. The package structure includes a header 310, a pad 320, a monitoring backlight 330, a can 340, a substrate 350, and a chip 360.

The header 310 may specifically be a DFB stamped header, and the chip 360 and other passive elements are packaged on the header.

The pad 320 is configured to adjust a position of the chip 360.

The chip 360 may specifically be a DFB chip.

Other elements such as the monitoring backlight 330 and the can 340 are similar to those in FIG. 1 and FIG. 2, and details are not described herein again.

FIG. 6 is a diagram of another EML TO packaging method according to an embodiment of this application. Corresponding to the EML TO package structure in FIG. 5, a specific packaging procedure includes steps S310 to S340.

S310: Obliquely attach the pad to the header with an 8-degree groove inclined surface using silver epoxy.

S320: Flatly attach the monitoring backlight to the pad in a laminated manner, and perform curing and fastening through high-temperature baking.

S330: Flatly attach the substrate and the chip to a post of the header sequentially at 90 degrees in a laminated manner, and complete eutectic bonding.

S340: Complete gold wire bonding required between all internal elements, and externally seal and weld the can.

In the foregoing three package structures, in the packaging using the EML vertical three-dimensional technology, a plurality of material elements need to be mounted a plurality of times in a package, a procedure is complex, packaging takes a long time, and packaging volume is large. In the EML horizontal packaging, an external optical reflector is required, a procedure is complex, and packaging volume is large. In the packaging using the DFB vertical three-dimensional technology, a spacer and a stamped header need to be added, packaging is complex, a procedure is complex and takes a long time, packaging costs are high, and packaging volume is large.

In view of this, this application provides a package structure, an optical module, and an optical communication device. A horizontal cavity surface-emitting laser chip integrated with a detection unit is disposed in the package structure, so that the simplest package form is implemented, a packaging procedure is simplified, and packaging volume is reduced.

This application provides a package structure. The package structure is a transistor outline (TO) package structure. The package structure includes the following structures.

A can and a header mate with each other to form a cavity structure. The can is provided with a transparent window.

A horizontal cavity surface-emitting laser (horizontal cavity surface-emitting laser, HCSEL) chip is disposed in the cavity structure formed by the can and the header. A plane in which the HCSEL chip is located is parallel to a mounting surface of the header, and an optical signal emitted by the HCSEL chip is directed toward the transparent window, so that the optical signal is transmitted outside through the transparent window provided in the can. A detection unit, or referred to as an integrated photodetector (photodetector, PD), is disposed in the HCSEL chip. The detection unit is configured to detect power of the optical signal emitted by the HCSEL chip.

In the package structure provided in this application, the HCSEL chip is disposed, so that an optical signal is emitted to the transparent window of the can when the chip is horizontally disposed. In a packaging process, no additional optical reflector needs to be added, thereby simplifying a packaging procedure and reducing packaging volume. In addition, based on use of the HCSEL chip, the detection unit is integrated into the HCSEL chip. In a packaging process, no additional monitoring backlight needs to be added, so that a packaging procedure is simplified, packaging volume is reduced, and the simplest package form is implemented.

The following describes a package structure of this application with reference to that the HCSEL chip is an HCSEL chip in an EML form and the HCSEL chip is specifically an HCSEL chip in a DFB form.

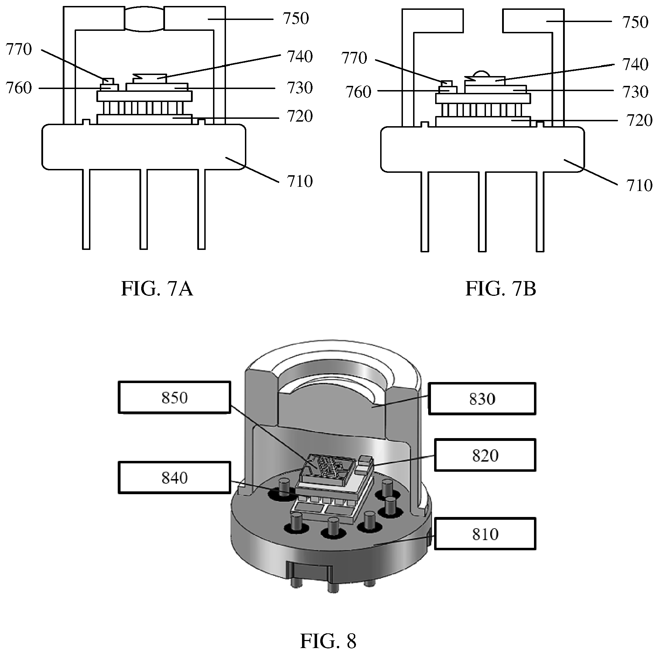

FIG. 7A and FIG. 7B are a diagram of a package structure including an HCSEL chip in an EML form according to an embodiment of this application. As shown in FIG. 7A and FIG. 7B, the package structure includes a header 710, a cooler 720, a substrate 730, an HCSEL chip 740, a can 750, a pad 760, and a thermistor 770.

The header 710 and the can 750 mate with each other to form a cavity structure. A plane in which the HCSEL chip 740 is located is parallel to a mounting surface of the header, and an optical signal emitted by the HCSEL chip is directed toward the transparent window, so that the optical signal is transmitted outside through the transparent window provided in the can.

The HCSEL chip 740 is specifically an HCSEL chip in an EML form. The chip in this form includes a light-emitting unit and an electroabsorption unit. The light-emitting unit is configured to emit a light beam, and the electroabsorption unit is configured to generate a photocurrent signal. The photocurrent signal generated by the electroabsorption unit is used to modulate the light beam transmitted by the light-emitting unit to generate the optical signal emitted by the HCSEL chip. In this case, the detection unit is the electroabsorption unit. Power of the optical signal emitted by the HCSEL chip is determined based on the photocurrent signal. Under a same operating point voltage, larger current input to the HCSEL chip indicates higher power of the optical signal emitted by the HCSEL chip and larger photocurrent generated by the electroabsorption unit, with a positive correlation between the two. This indicates that the photocurrent signal generated by the electroabsorption unit may function similarly to an integrated photodetector, and can be used as the detection unit. In this way, the power of the optical signal emitted by the HCSEL chip can be detected through the photocurrent fed back by the electroabsorption unit, thereby implementing high density and high integration of the HCSEL chip. In addition, no additional backlight monitoring needs to be added to the package structure, and packaging is simplified.

Specifically, that the plane in which the HCSEL chip 740 is located is parallel to the mounting surface of the header may be understood as any one of the following forms, or another form similar to any one of the following forms.
(a) The HCSEL chip 740 is flatly attached to the mounting surface of the header 710.
(b) The package structure further includes the cooler 720. The cooler is disposed on the mounting surface of the header. The HCSEL chip 740 is flatly attached to the cooler 720.
(c) The substrate 730 is disposed on the mounting surface of the header 710. The HCSEL chip 740 is flatly attached to the substrate 730.
(d) The substrate 730 is disposed on the mounting surface of the header 710. The cooler is mounted on a surface of the substrate 730. The HCSEL chip 740 is flatly attached to the cooler.

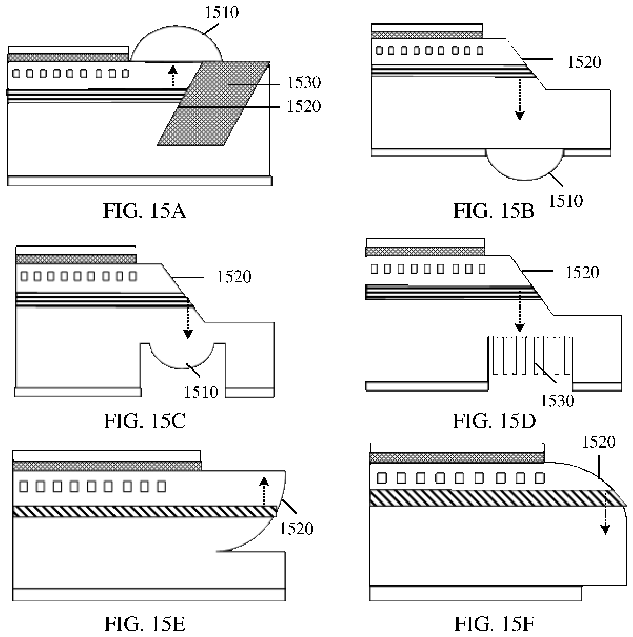

In the structure shown in FIG. 7A and FIG. 7B, the transparent window provided in the can 750 may be shown in FIG. 7A, is a lens structure, and is configured to focus the optical signal emitted by the HCSEL chip 740, so that the optical signal is emitted in a collimated manner. Alternatively, as shown in FIG. 7B, a window devoid of a structure or a window including a transparent medium may be provided. This is not limited in this application. In this case, a lens interface may be disposed on the emission aperture of the HCSEL chip 740. A specific arrangement manner is described below with reference to FIG. 15A to FIG. 15F.

FIG. 8 is a three-dimensional diagram of a package structure including an HCSEL chip in an EML form according to an embodiment of this application. A header 810, a thermistor 820, a can 830, a cooler 840, and an HCSEL chip 850 disposed in FIG. 8 respectively correspond to the header 710, the thermistor 770, the can 750, the cooler 720, and the HCSEL chip 740 in FIG. 7A and FIG. 7B, and details are not described herein again.

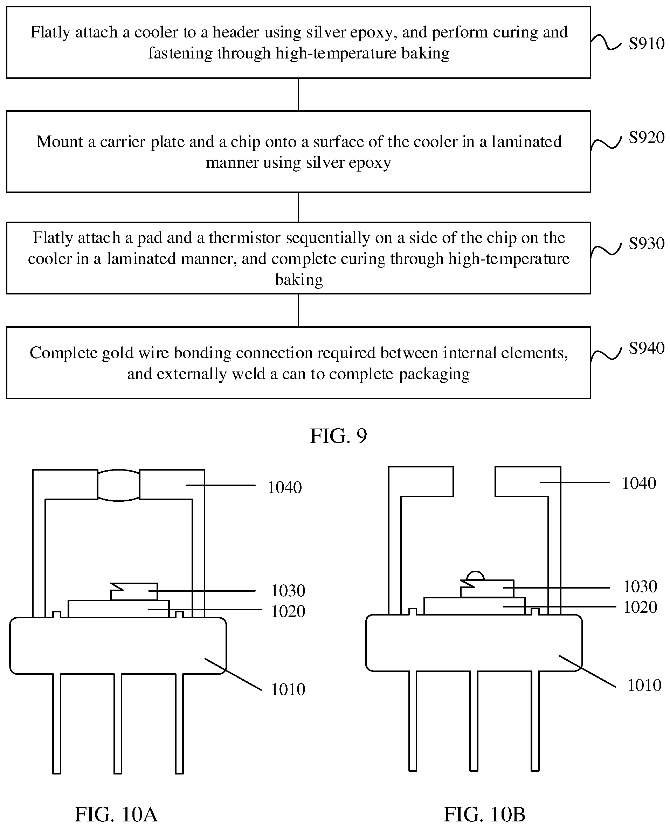

FIG. 9 is a diagram of a packaging method including an HCSEL chip in an EML form according to an embodiment of this application. Corresponding to the package structures in FIG. 7A and FIG. 7B and FIG. 8, the packaging method includes steps S910 to S940.

S910: Flatly attach the cooler to the header using silver epoxy, and perform curing and fastening through high-temperature baking.

S920: Mount a carrier plate and the chip onto a surface of the cooler in a laminated manner using silver epoxy.

S930: Flatly attach the pad and the thermistor sequentially on a side of the chip on the cooler in a laminated manner, and complete curing through high-temperature baking.

S940: Complete gold wire bonding connection required between internal elements, and externally weld the can to complete packaging.

In the foregoing package structure and the packaging method of the HCSEL chip in the EML form, the HCSEL chip is disposed, so that an optical signal is emitted to the transparent window of the can when the chip is horizontally disposed. In a packaging process, no additional optical reflector needs to be added, thereby simplifying a packaging procedure and reducing packaging volume. In addition, based on use of the HCSEL chip, the photocurrent signal fed back by the absorption unit of the HCSEL chip in the EML form is used as feedback. In a packaging process, no additional monitoring backlight needs to be added, so that a packaging procedure is simplified, and packaging volume is reduced. In addition, the HCSEL chip may be directly flatly attached to the header, a lead is directly connected to a signal pin of the header, and it is not necessary to add a radio frequency signal substrate to ensure high-speed signal drainage. Alternatively, the HCSEL chip may be directly flatly attached to the cooler, and no heat sink needs to be added to dissipate heat. In this way, the simplest package form is implemented.

FIG. 10A and FIG. 10B are a diagram of a package structure including an HCSEL chip in a DFB form according to an embodiment of this application. As shown in FIG. 10A and FIG. 10B, the package structure includes a header 1010, a substrate 1020, an HCSEL chip 1030, and a can 1040.

The header 1010 and the can 1040 mate with each other to form a cavity structure. A plane in which the HCSEL chip 1030 is located is parallel to a mounting surface of the header, and an optical signal emitted by the HCSEL chip is directed toward the transparent window, so that the optical signal is transmitted outside through the transparent window provided in the can.

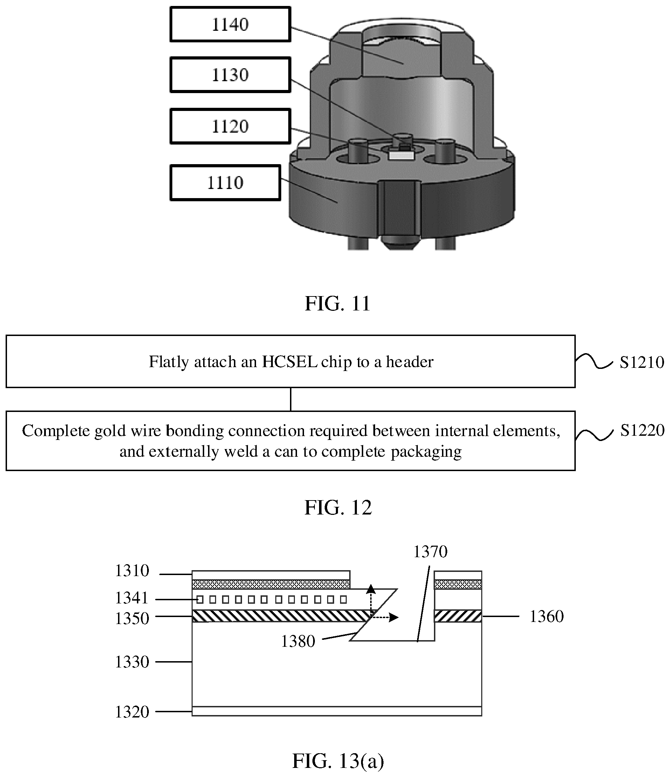

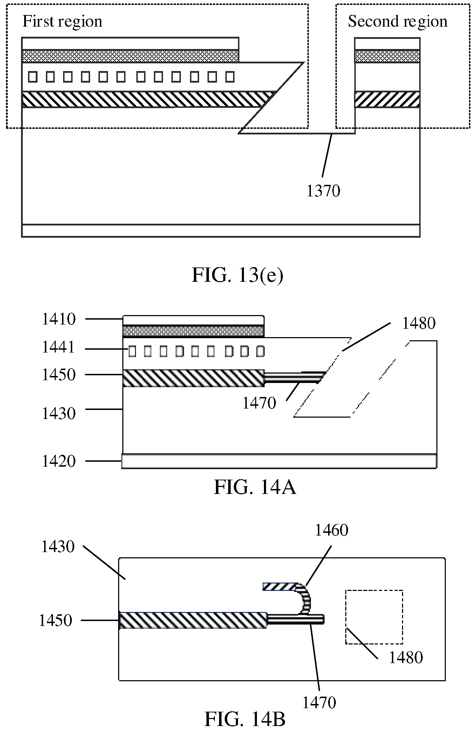

The HCSEL chip 1030 is specifically an HCSEL chip in a DFB form, and implements single-mode optical signal output by introducing periodic refractive index modulation into a waveguide structure. In the HCSEL chip in the DFB form, the detection unit may be formed by a photoresistor. The photoresistor is disposed on the HCSEL chip, so that the power of the optical signal emitted by the HCSEL chip can be detected, thereby implementing high density and high integration of the HCSEL chip. In addition, no additional backlight monitoring needs to be added to the package structure, and packaging is simplified. A specific integrated structure of the chip is described with reference to FIG. 13(a) to FIG. 13(e) and FIG. 14A and FIG. 14B below.

Specifically, that the plane in which the HCSEL chip 1030 is located is parallel to the mounting surface of the header may be understood as any one of the following forms, or another form similar to any one of the following forms.
(a) The HCSEL chip 1030 is flatly attached to the mounting surface of the header 1010.
(b) The package structure further includes the cooler. The cooler is disposed on the mounting surface of the header. The HCSEL chip 1030 is flatly attached to the cooler.
(c) The substrate 1020 is disposed on the mounting surface of the header 1010. The HCSEL chip 1030 is flatly attached to the substrate 1020.
(d) The substrate 1020 is disposed on the mounting surface of the header 1010. The cooler is mounted on a surface of the substrate 1020. The HCSEL chip 1030 is flatly attached to the cooler.

In the structure shown in FIG. 10A and FIG. 10B, the transparent window provided in the can 1040 may be shown in FIG. 10A, is a lens structure, and is configured to focus the optical signal emitted by the HCSEL chip 1030, so that the optical signal is emitted in a collimated manner. Alternatively, as shown in FIG. 10B, a window devoid of a structure or a window including a transparent medium may be provided. This is not limited in this application. In this case, the lens structure may be integrated into the HCSEL chip 1030. A specific arrangement manner is described below with reference to FIG. 15A to FIG. 15F.

FIG. 11 is a three-dimensional diagram of a package structure including an HCSEL chip in a DFB form according to an embodiment of this application. A header 1110, a substrate 1120, an HCSEL chip 1130, and a can 1140 disposed in FIG. 11 respectively correspond to the header 1010, the substrate 1020, the HCSEL chip 1030, and the can 1040 in FIG. 10A and FIG. 10B, and details are not described herein again.

FIG. 12 is a diagram of a packaging method including an HCSEL chip in a DFB form according to an embodiment of this application. Corresponding to the package structures in FIG. 10A and FIG. 10B and FIG. 11, the packaging method includes steps S1010 and S1020.

S1210: Flatly attach the HCSEL chip to the header; flatly attach the substrate to the header and then flatly attach the HCSEL chip to the substrate in a laminated manner; flatly attach the cooler to the header and then flatly attach the HCSEL chip to the cooler in a laminated manner; or flatly attach the substrate to the header, then flatly attach the cooler to the substrate in a laminated manner, and then flatly attach the HCSEL chip to the cooler in a laminated manner.

S1220: Complete gold wire bonding connection required between internal elements, and externally weld the can to complete packaging.

In the foregoing package structure and the packaging method of the HCSEL chip in the DFB form, the HCSEL chip is disposed, so that an optical signal is emitted to the transparent window of the can when the chip is horizontally disposed. In a packaging process, no additional optical reflector needs to be added, thereby simplifying a packaging procedure and reducing packaging volume. In addition, based on use of the HCSEL chip, the detection unit is integrated into the HCSEL chip. In a packaging process, no additional monitoring backlight needs to be added, so that a packaging procedure is simplified, and packaging volume is reduced. In addition, no excessive resistors or capacitors need to be added, thereby implementing the simplest package form.

FIG. 13(a) to FIG. 13(e) are diagrams of a structure of an HCSEL chip according to an embodiment of this application. As shown in FIG. 13(a) to FIG. 13(e), the HCSEL chip includes a first electrode 1310, a second electrode 1320, and a semiconductor substrate 1330. The first electrode 1310 and the second electrode 1320 may be disposed on a same surface or different surfaces of the semiconductor substrate 1330. The first electrode 1310 may be made of a P-type metal, and the second electrode 1320 may be made of an N-type metal. In some implementations, the first electrode 1310 may include a P-type metal and an InGaAsP material. This is not limited in this application.

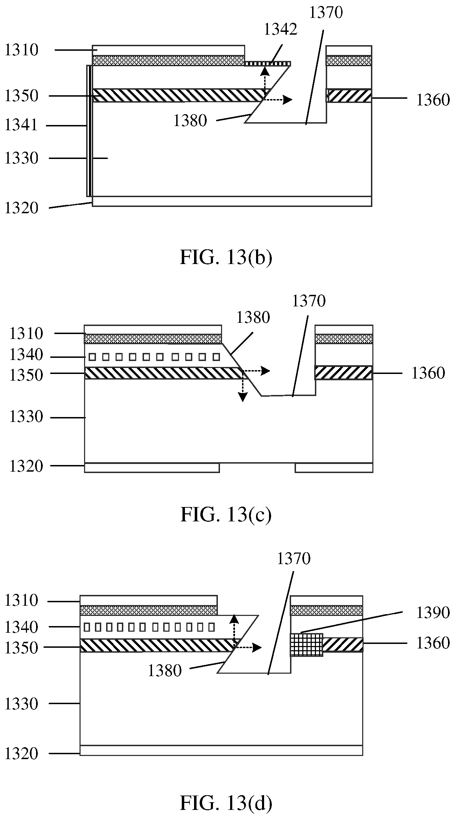

In some implementations, the HCSEL chip further includes an optical reflection element. The optical reflection element is configured to form a resonant cavity in a first region, and after the photon is amplified by mode selection in the resonant cavity, an emergent optical signal is formed. A specific structure of the optical reflection element may have two composition manners as shown in FIG. 13(a) and FIG. 13(b). In FIG. 13(a), the optical reflection element includes a deep reactive ion etching (deep reactive ion etching, DRB) grating 1341. As shown in FIG. 13(b), the optical reflection element includes a high reflectivity (high reflectivity, HR) film 1341 attached to a side of the semiconductor substrate 1330. In some implementations, an anti-reflection (anti-reflection, AR) film 1342 is further attached to a side of the emission aperture. In some implementations, the methods shown in FIG. 13(a) and FIG. 13(b) may be combined with each other. This is not limited in this application.

The semiconductor substrate 1330 specifically includes a first region, a second region, and an isolation trench 1370. The first region and the second region are respectively located on two sides of the isolation trench 1370, that is, the first region and the second region are isolated by the isolation trench 1370. For division of the first region and the second region, refer to FIG. 13(e).

A light-emitting layer 1350 is disposed in the first region. The light-emitting layer 1350 may be formed by an active material or by connecting an active material to a passive material. The light-emitting layer 1350 includes a first light-emitting facet and a second light-emitting facet. The first light-emitting facet is connected to a side of the semiconductor substrate. The second light-emitting facet is connected to a reflective inclined surface 1380. In the light-emitting layer, the second emission facet is configured to emit a first optical signal. After the second laser transmit facet emits the optical signal, a part of the optical signal passes through the connected reflective inclined surface 1380 to form a second optical signal perpendicular to a plane in which the HCSEL chip is located, and is emitted from the HCSEL chip. A part of the optical signal passes through the connected reflective inclined surface 1380 to form a third optical signal parallel to a plane in which the HCSEL chip is located, passes through the isolation trench 1370, and enters the second region.

A detection unit 1360 is disposed in the second region. The detection unit 1360 and the light-emitting layer 1350 are located in a same plane to receive the third optical signal that enters the second region to detect the optical signal. In some implementations, as shown in FIG. 13(d), the detection unit 1360 may include an amplification unit 1390. The amplification unit 1390 may be a semiconductor optical amplifier (semiconductor optical amplifier, SOA), and is configured to amplify the third optical signal to facilitate optical detection performed by the detection unit.

It should be understood that an arrangement position of the isolation trench 1370 is not limited in this application. The isolation trench is configured to isolate the light-emitting layer in the first region from the detection unit in the second region to prevent a problem such as photoelectric crosstalk. In some implementations, the isolation trench includes a first sidewall, and the first sidewall is the reflective inclined surface 1380. That is, a specific position of the isolation trench is defined by the reflective inclined surface, thereby saving space and optimizing the structural design of the HCSEL chip.

It should be understood that a specific angle set for the reflective inclined surface 1380 in the first region is not limited in this application. For example, the angle of the reflective inclined surface 1380 may be 45°. In some cases, the reflective inclined surface 1380 may alternatively be a reflector. In some cases, the reflective inclined surface 1380 is formed by etching.

It should be understood that, a specific emission position of the second optical signal on the HCSEL chip is not limited in this application. In some cases, the HCSEL chip includes an emission aperture, and the emission aperture is configured to output the second optical signal. A specific position of the emission aperture is not limited in this application. For example, as shown in FIG. 13(a), FIG. 13(b), and FIG. 13(d), the emission aperture may be located in a first plane of the semiconductor substrate 1330, and the first plane may be a plane of the semiconductor substrate 1330 adjacent to the first electrode 1310. Alternatively, as shown in FIG. 13(c), the emission aperture may be located on a second plane of the semiconductor substrate 1330, and the second plane may be a plane of the semiconductor substrate 1330 adjacent to the second electrode 1320. A specific position of the emission aperture is determined based on the reflective inclined surface 1380.

In the structure shown in FIG. 13(a) to FIG. 13(e), the detection unit is disposed in the chip, so that a high-density and high-integration chip structure is implemented. In addition, based on division of the isolation trenches, the first light-emitting facet of the light-emitting layer is connected to the semiconductor substrate, and the optical signal received by the second detection unit is from the second light-emitting facet of the light-emitting layer, that is, an emission facet that is specifically located on a side of the reflective inclined surface in the specific HCSEL chip, to avoid providing the isolation trench and an isolation region in a reverse direction of the emission facet of the HCSEL chip to place the detection unit, thereby optimizing a chip structure and saving chip space. When one sidewall of the isolation trench is a reflective inclined surface, space can be further saved, and structural design of the HCSEL chip can be optimized.

FIG. 14A and FIG. 14B are a diagram of a structure of another HCSEL chip according to an embodiment of this application. As shown in FIG. 14A and FIG. 14B, the HCSEL chip includes a first electrode 1410, a second electrode 1420, and a semiconductor substrate 1430. A specific arrangement manner of the first electrode 1410 and the second electrode 1420 is similar to that of the first electrode 1310 and the second electrode 1320 in FIG. 13(a) to FIG. 13(e), and arrangement of an optical reflection element 1441 is similar to that of the optical reflection element 1341 in FIG. 13(a) to FIG. 13(e), and details are not described herein again. The semiconductor substrate 1430 specifically includes a light-emitting layer 1450, a detection unit 1460, a beam splitting unit 1470, and a reflective inclined surface 1480.

The light-emitting layer 1450 in FIG. 14A and FIG. 14B includes a first light-emitting facet and a second light-emitting facet. The first emission facet is connected to a side of the semiconductor substrate.

The optical splitting unit 1470 is configured to split the first optical signal output from the second light-emitting facet, and includes an input port, a first output port, and a second output port. Specific arrangement of the beam splitting unit 1470 is shown in a cross-sectional view of a side view angle FIG. 14A and a cross-sectional view of a top view angle FIG. 14B.

The input port of the beam splitting unit 1470 is connected to the second light-emitting facet, the first output port is connected to the detection unit, and the second output port is connected to the reflective inclined surface 1480. In this way, after the first optical signal is input to the beam splitting unit from the input port, a part of the optical signal is output from the first output port, and a part of the optical signal is output from the second output port. The part of signal light output from the second port is reflected from the reflective inclined surface 1480 to form a second optical signal perpendicular to a plane in which the HCSEL chip is located, and is emitted from the HCSEL chip. A third optical signal output from the first port is input to the detection unit, and the detection unit performs optical detection on the third optical signal. The beam splitting unit may alternatively be a beam splitter, and split ratios of the first output port and the second output port of the beam splitting unit may be adjusted.

In some implementations, the detection unit 1460 includes an amplification unit. Similar to FIG. 13(a) to FIG. 13(e), the amplification unit is configured to amplify the third optical signal to facilitate optical detection performed by the detection unit.

In the structure shown in FIG. 14A and FIG. 14B, the detection unit is disposed in the chip, so that a high-density and high-integration chip structure is implemented. In addition, the beam splitting unit is provided on the second emission facet of the semiconductor substrate, to avoid providing the isolation trench and an isolation region in a reverse direction of the emission facet of the HCSEL chip to place the detection unit, thereby optimizing a chip structure and saving chip space.

It should be understood that the optical signals (the first optical signal, the second optical signal, and the third optical signal) described in FIG. 13(a) to FIG. 13(e) and FIG. 14A and FIG. 14B may specifically be laser signals or optical signals in other forms. This is not limited in this application.

FIG. 15A to FIG. 15F are a diagram of a structure of another HCSEL chip according to an embodiment of this application. As shown in FIG. 15A to FIG. 15F, the HCSEL chip includes a first electrode, a second electrode, an optical reflection element, and a semiconductor substrate. The semiconductor substrate includes a light-emitting layer and a reflective inclined surface 1520. A specific arrangement manner of the first electrode, the second electrode, and the optical reflection element and specific arrangement of the reflective inclined surface 1520 included in the semiconductor substrate are similar to those in FIG. 13(a) to FIG. 13(e) and FIG. 14A and FIG. 14B, and details are not described herein again.

In some implementations, as shown in FIG. 15A, FIG. 15B, and FIG. 15C, the HCSEL chip includes an emission aperture, the emission aperture is of a cambered surface structure, and a specific position of the emission aperture is determined based on the reflective inclined surface 1520. A specific position of the emission aperture is not limited in this application. The emission aperture is configured to output an optical signal emitted by the HCSEL chip. After passing through a cambered surface structure of the emission aperture, the optical signal is focused, to achieve an effect similar to that of an optical lens, so that the optical signal is emitted from the HCSEL chip in a collimated manner. It should be understood that a manner of preparing the emission aperture into the cambered surface structure is not limited in this application. For example, in a case of FIG. 15A and FIG. 15B, the spherical structure is formed by solidifying an adhesive, or may be understood as a drop glue method, that is, the spherical structure is formed by solidifying low-refractive-index glue, to implement a low-cost and easy-to-prepare spherical structure preparation solution. In the case of FIG. 15A, there is an isolation trench 1530 or another non-flat shape at a position of the HCSEL chip close to the emission aperture. In this case, flatness processing may be first performed by using low-refractive-index glue, and then the cambered surface structure is formed at the position of the emission aperture of the HCSEL chip using a drop glue method. In a case of FIG. 15C, for example, the spherical structure is formed using a method for etching a base.

In some implementations, as shown in FIG. 15D, emission apertures are provided in the HCSEL chip, and the emission apertures are periodically arranged. The HCSEL chip includes the emission apertures. The emission aperture is configured to output an optical signal emitted by the HCSEL chip. After passing through the periodically arranged structure of the emission apertures, a far-field divergence angle of the optical signal is small, to achieve an effect similar to that of an optical lens, so that the optical signal is emitted from the HCSEL chip in a collimated manner. In some cases, the periodically arranged structures are formed by the metasurface techniques.

In some implementations, as shown in FIG. 15E and FIG. 15F, the reflective inclined surface 1520 is a cambered surface structure, and the reflective inclined surface 1520 is configured to reflect the optical signal emitted by the light-emitting layer included in the HCSEL chip. After passing through the cambered surface structure of the reflective inclined surface 1520, the optical signal is focused, to achieve an effect similar to that of an optical lens, so that the optical signal is emitted from the HCSEL chip in a collimated manner. In some cases, the cambered surface structure of the reflective inclined surface 1520 is formed using a grayscale exposure process or another similar process.

In the diagram of the structure of the HCSEL chip shown in FIG. 15A to FIG. 15F, a lens or a structure having a similar effect with the lens is integrated into the chip, to implement a high-density and high-integration chip structure.

The foregoing describes the package structure and the HCSEL chip structure in this application with reference to specific embodiments. The following describes a specific implementation mode of the package structure in this application.

In some implementations, the package structure may include only one HCSEL chip, and the package structure is a light-emitting component in a single-transmit mode.

In some implementations, in addition to one HCSEL chip, the package structure further includes one or more light-emitting chips, and the package structure is a light-emitting component in a multi-transmit mode, so that a package structure of a transmit end is simplified, packaging volume is reduced, and optical component costs are reduced.

In some implementations, in addition to one HCSEL chip, the package structure further includes one or more light-receiving chips, and the package structure is an optical transceiver in a one-transmit-one-receive mode or a one-transmit-multi-receive mode, so that package structures of a transmit end and a receive end are simplified, packaging volume is reduced, and optical component costs are reduced.

In some implementations, the package structure further includes one or more light-emitting chips and one or more light-receiving chips, and the package structure is an optical transceiver in a multi-transmit multi-receive mode, so that package structures of a transmit end and a receive end are simplified, packaging volume is reduced, and optical component costs are reduced.

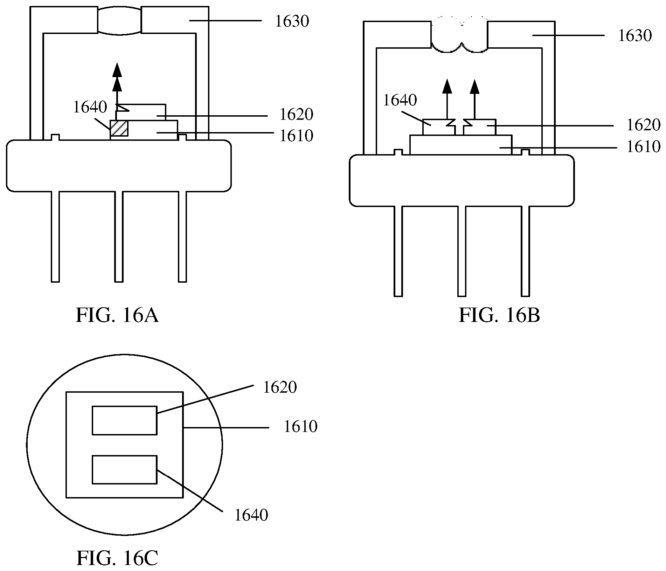

FIG. 16A to FIG. 16C are a diagram of a case in which a package structure is a light-emitting component according to an embodiment of this application. That is, the package structure includes an HCSEL chip 1620 and one or more light-emitting chips. The HCSEL chip and the light-emitting chip in the package structure are configured to output an optical signal based on a received electrical signal. The one or more light-emitting chips may be any chip configured to emit an optical signal, for example, a vertical cavity surface-emitting laser chip, a Fabry-Perot laser chip, an EML chip, or a DFB chip, or the HCSEL chip described in FIG. 13(a) to FIG. 13(e), FIG. 14A and FIG. 15B, and FIG. 15A to FIG. 15F. The one or more light-emitting chips may be the same or different. This is not limited in this application.

In some implementations, as shown in FIG. 16A, the HCSEL chip and one or more light-emitting chips may be located in different planes. The HCSEL chip and one or more light-emitting chips may be disposed at different orientations of the substrate 1610. In a case shown in FIG. 16A, transmission paths of optical signals transmitted by the HCSEL chip 1620 and the light-emitting chip 1640 overlap.

In some implementations, as shown in FIG. 16B and FIG. 16C, the HCSEL chip and one or more light-emitting chips may be located in a same plane. For example, as shown in FIG. 16B and FIG. 16C, the HCSEL chip 1620 and the light-emitting chip 1640 may be disposed at a same orientation of the substrate 1610. In some implementations, the transparent window of the can 1630 may include a plurality of optical lenses, to ensure that an optical signal is emitted from the package structure in a collimated manner. Alternatively, the optical lens may be integrated into the HCSEL chip and the light-emitting chip, as shown in FIG. 15A to FIG. 15F. This is not limited in this application.

The HCSEL chip, the light-emitting chip, and the light-receiving chip in the optical transceiver may be mounted in an active mounting manner or a passive mounting manner. The active mounting may be understood as that the package structure includes an optical element having an active function, for example, an optical modulator. Through the active coupling, a plurality of light beams may be integrated in different dimensions, that is, the overall package is externally represented as a single-beam optical path element including different optical signals. The passive mounting may be understood as that the package structure includes only optical elements having passive functions, for example, an optical isolator, a splitter, and an optical switch. Through the passive mounting, a plurality of light beams may be integrated in different dimensions, that is, the overall package is externally represented as a single-beam optical path element including different optical signals.

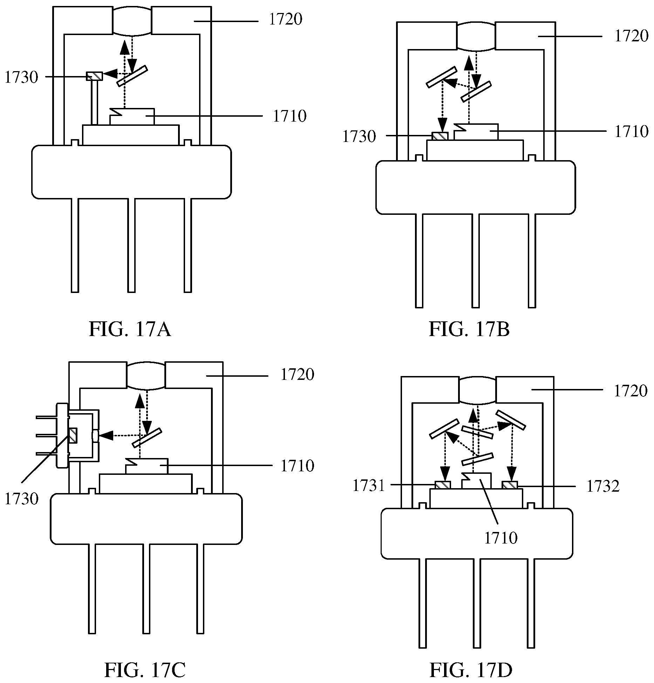

FIG. 17A to FIG. 17D are a diagram of a case in which a package structure is an optical transceiver according to an embodiment of this application. That is, the package structure includes at least an HCSEL chip 1710 and one light-receiving chip. In some implementations, the package structure may further include one or more light-receiving chips.

The HCSEL chip and the light-emitting chip in the package structure are configured to output an optical signal based on a received electrical signal. The light-receiving chip is configured to convert the received optical signal into an electrical signal and output the electrical signal. The one or more light-emitting chips may be any chip configured to emit an optical signal, for example, a vertical cavity surface-emitting laser chip, a Fabry-Perot laser chip, an EML chip, or a DFB chip, or the HCSEL chip described in FIG. 13(a) to FIG. 13(e), FIG. 14A and FIG. 14B, FIG. 15A to FIG. 15F. This is not limited in this application. The one or more light-emitting chips may be the same or different. This is not limited in this application. The one or more light-receiving chips may be photodiode chips or photomultiplier tube chips, for example, may be an avalanche photodiode (avalanche photodiode, APD) chip. This is not limited in this application. The one or more light-receiving chips may be the same or different. This is not limited in this application.

In some implementations, as shown in FIG. 17A, at least one post is disposed in the package structure. A first chip is mounted on the post. The post is configured to adjust a position height of the first chip, so that an optical signal emitted by a first chip is aligned with a transparent window provided in a can 1720, or the first chip can receive an optical signal emitted from the transparent window provided in the can 1720. The first chip may be any one of a light-receiving chip, a light-emitting chip, or the HCSEL chip described in FIG. 13(a) to FIG. 13(e), FIG. 14A and FIG. 14B, and FIG. 15A to FIG. 15F.

In some implementations, as shown in FIG. 17A to FIG. 17D, at least one prism is disposed in the package structure. A prism in the at least one prism may be disposed between a second chip and a transparent window provided in the can 1720. The prism in the at least one prism is configured to adjust an optical transmission path between the can and the second chip, so that an optical signal emitted by the second chip is aligned with the transparent window provided in a can 1720, or the first chip can receive an optical signal emitted from the transparent window provided in the can 1720. The second chip may be any one of a light-receiving chip, a light-emitting chip, or the HCSEL chip described in FIG. 13(a) to FIG. 13(e), FIG. 14A and FIG. 14B, and FIG. 15.

A specific arrangement manner and position of the post and the prism are determined according to an actual case. For example, as shown in FIG. 17A, one post and one prism may be disposed in the package structure, so that a light-receiving chip 1730 receives the optical signal emitted from the transparent window provided in the can 1720. As shown in FIG. 17B, a group of prisms (two prisms) may be disposed in the package structure, so that the light-receiving chip 1730 receives the optical signal emitted from the transparent window provided in the can 1720. As shown in FIG. 17D, two groups of prisms (two prisms in each group) may be disposed in the package structure, so that light-receiving chips 1731 and 1732 can receive, through respective corresponding prism groups, optical signals emitted from the transparent window provided in the can 1720.

In some implementations, as shown in FIG. 17C, the package structure further includes a sub-package structure. A third chip is disposed in the self-package structure. The third chip may be any one of a light-receiving chip, a light-emitting chip, or the HCSEL chip described in FIG. 13(a) to FIG. 13(e), FIG. 14A and FIG. 14B, and FIG. 15A to FIG. 15F.

The HCSEL chip, the light-emitting chip, and the light-receiving chip in the optical transceiver may be mounted in an active mounting manner or a passive mounting manner. The active mounting may be understood as that the package structure includes an optical element having an active function, for example, an optical modulator. Through the active coupling, a plurality of light beams may be integrated in different dimensions, that is, the overall package is externally represented as a single-beam optical path element including different optical signals. The passive mounting may be understood as that the package structure includes only optical elements having passive functions, for example, an optical isolator, a splitter, and an optical switch. Through the passive mounting, a plurality of light beams may be integrated in different dimensions, that is, the overall package is externally represented as a single-beam optical path element including different optical signals.

In addition, this application further provides an optical module and an optical communication device, including the package structure described in FIG. 5 to FIG. 12 or FIG. 16A to FIG. 16C and FIG. 17A to FIG. 17D.

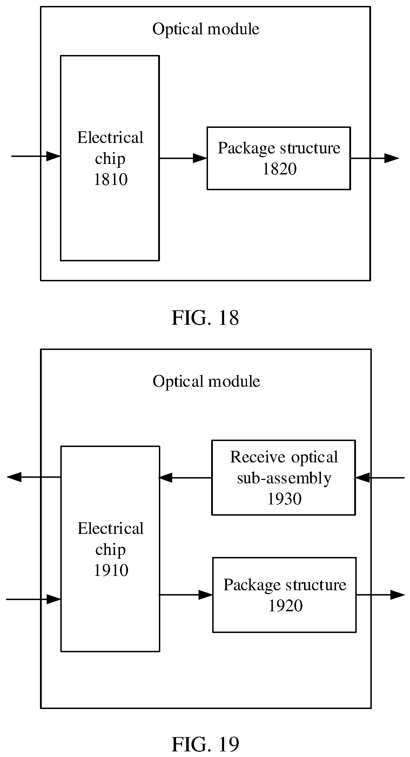

FIG. 18 shows an optical module according to an embodiment of this application. As shown in FIG. 18, the optical module includes an electrical chip 1810 and the foregoing package structure 1820. The electrical chip 1810 is electrically connected to an HCSEL chip in the package structure 1820. The electrical chip 1810 is configured to generate an electrical signal. The electrical signal carries data. The HCSEL chip is configured to generate an optical signal based on the electrical signal. In this way, the electrical chip 1810 modulates the optical signal emitted by the HCSEL chip to complete optical-to-electrical conversion of the signal.

When the package structure is the integrated structure described in FIG. 16A to FIG. 16C and FIG. 17A to FIG. 17D, the electrical chip 1810 may be electrically connected to any chip included in the package structure 1820, so that any optical sending chip may transmit the corresponding optical signal based on the electrical signal generated by the electrical chip 1810, any light-receiving chip may convert the received optical signal into another electrical signal, and the electrical chip 1810 may convert the another electrical signal into corresponding data.

FIG. 19 shows another optical module according to an embodiment of this application. As shown in FIG. 19, the optical module includes an electrical chip 1910, a receive optical sub-assembly 1920, and the foregoing package structure 1930.

The electrical chip 1910 is electrically connected to an HCSEL chip in the package structure. The electrical chip is configured to generate an electrical signal. The electrical signal carries data. The HCSEL chip is configured to generate an optical signal based on the electrical signal. In this way, the electrical chip modulates the optical signal emitted by the HCSEL chip to complete optical-to-electrical conversion of the signal.

The electrical chip 1910 is electrically connected to the receive optical sub-assembly 1920. The receive optical sub-assembly 1920 is configured to receive another optical signal and convert the another optical signal into another electrical signal. The electrical chip 1910 is configured to obtain another piece of data based on the another electrical signal. Therefore, the electrical chip processes the optical signal received by the receive optical sub-assembly to obtain data.

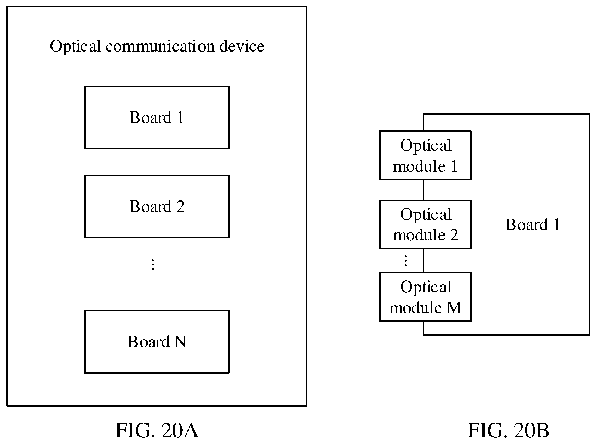

FIG. 20A and FIG. 20B show an optical communication device according to an embodiment of this application. As shown in FIG. 20A and FIG. 20B, N boards, for example, a board 1, a board 2, ..., and a board N shown in FIG. 20A, are included. Each of the N boards includes one or more optical modules described in FIG. 18 or FIG. 19. For example, a board 1 is shown in FIG. 20B. The board specifically includes an optical module 1, an optical module 2, ..., and an optical module M. Each optical module includes a package structure. A specific form of the optical communication device is determined according to an actual case, and may be, for example, an optical transmission device, an optical access device, or an optical switching device.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

## Claims

1. A package structure, wherein the package structure is a transistor outline package structure, and the package structure comprises:
a can, provided with a transparent window;
a header, mated with the can to form a cavity structure; and
a horizontal cavity surface-emitting laser HCSEL chip, disposed in the cavity structure, wherein a plane in which the HCSEL chip is located is parallel to a mounting surface of the header, and an optical signal emitted by the HCSEL chip is directed toward the transparent window, wherein
a detection unit is disposed in the HCSEL chip, and the detection unit is configured to detect power of the optical signal emitted by the HCSEL chip.

2. The package structure according to claim 1, wherein the HCSEL chip is in an electroabsorption modulated laser EML form, wherein
the HCSEL chip in the EML form comprises a light-emitting unit and an electroabsorption unit, the light-emitting unit is configured to emit a light beam, the electroabsorption unit is configured to generate a photocurrent signal, the photocurrent signal is used to modulate the light beam to generate the optical signal emitted by the HCSEL chip, the detection unit is the electroabsorption unit, and the power of the optical signal emitted by the HCSEL chip is determined based on the photocurrent signal.

3. The package structure according to claim 1, wherein the horizontal cavity surface-emitting laser chip is in a distributed feedback DFB form, and in the HCSEL chip in the DFB form, the optical detection unit is formed by a photoresistor.

4. The package structure according to claim 3, wherein the horizontal cavity surface-emitting laser chip comprises a first electrode, a second electrode, and a semiconductor substrate, the semiconductor substrate comprises a first region, a second region, and an isolation trench, and the first region and the second region are respectively located on two sides of the isolation trench, wherein
a light-emitting layer and a reflective inclined surface are disposed in the first region, wherein
the light-emitting layer comprises a first light-emitting facet and a second light-emitting facet, the first light-emitting facet is connected to a side of the semiconductor substrate, and the second light-emitting facet is connected to the reflective inclined surface; and
the detection unit is disposed in the second region, wherein
the detection unit and the light-emitting layer are located in a same plane.

5. The package structure according to claim 4, wherein the isolation trench comprises a first sidewall, and the first sidewall is the reflective inclined surface.

6. The package structure according to claim 3, wherein the horizontal cavity surface-emitting laser chip comprises a first electrode, a second electrode, and a semiconductor substrate, and a light-emitting layer, a reflective inclined surface, a beam splitting unit, and the optical detection unit are disposed in the semiconductor substrate, wherein
the light-emitting layer comprises a first light-emitting facet and a second light-emitting facet, and the first emission facet is connected to a side of the semiconductor substrate; and
the optical splitting unit comprises an input port, a first output port, and a second output port, the input port is connected to the second light-emitting facet, the first output port is connected to the detection unit, and the second output port is connected to the reflective inclined surface.

7. The package structure according to any one of claims 1 to 6, wherein the package structure further comprises a cooler, and the HCSEL chip is flatly attached to the cooler.

8. The package structure according to any one of claims 1 to 7, wherein
the HCSEL chip comprises an emission aperture, and the emission aperture is a spherical structure; and
the reflective inclined surface is a spherical structure.

9. The package structure according to claim 8, wherein
the package structure is a light-emitting component in a single-transmit mode;
the package structure further comprises one or more light-emitting chips, and the package structure is a light-emitting component in a multi-transmit mode;
the package structure further comprises one or more light-receiving chips, and the package structure is an optical transceiver in a one-transmit-one-receive mode or a one-transmit-multi-receive mode; or
the package structure further comprises one or more light-emitting chips and one or more light-receiving chips, and the package structure is an optical transceiver in a multi-transmit multi-receive mode.

10. An optical module, comprising an electrical chip and the package structure according to any one of claims 1 to 9, wherein
the electrical chip is configured to generate an electrical signal, wherein the electrical signal carries data; and
the HCSEL chip is configured to generate an optical signal based on the electrical signal.

11. An optical module, comprising an electrical chip, a receive optical sub-assembly, and the package structure according to any one of claims 1 to 9, wherein
the electrical chip is configured to generate an electrical signal, wherein the electrical signal carries data;
the HCSEL chip is configured to generate an optical signal based on the electrical signal;
the receive optical sub-assembly is configured to receive another optical signal and convert the another optical signal into another electrical signal; and
the electrical chip is further configured to obtain another piece of data based on the another electrical signal.

12. An optical communication device, comprising N boards, wherein each of the N boards comprises one or more optical modules according to claim 10 or 11.

13. A packaging method, used to prepare the package structure according to any one of claims 1 to 9.

14. An optical chip, comprising a first electrode, a second electrode, and a semiconductor substrate, wherein the semiconductor substrate comprises a first region, a second region, and an isolation trench, and the first region and the second region are respectively located on two sides of the isolation trench, wherein
a light-emitting layer and a reflective inclined surface are disposed in the first region, wherein
the light-emitting layer comprises a first light-emitting facet and a second light-emitting facet, the first light-emitting facet is connected to a side of the semiconductor substrate, and the second light-emitting facet is connected to the reflective inclined surface; and
the detection unit is disposed in the second region, wherein
the detection unit and the light-emitting layer are located in a same plane.

15. The optical chip according to claim 14, wherein the isolation trench comprises a first sidewall, and the first sidewall is the reflective inclined surface.
